# FASCICULE DE BREVET EUROPEEN

(11) **EP 4 568 892 B1**
(45) Date de publication et mention de la délivrance du brevet: **30.09.2026**
(21) Numéro de dépôt: 23758702.7
(22) Date de dépôt: 04.08.2023
(51) Int. Cl.: B64D 27/24

(54) **SYSTEME ELECTRIQUE D'UNE PROPULSION ELECTRIQUE D'UN AERONEF**
ELEKTRISCHES SYSTEM EINES ELEKTRISCHEN ANTRIEBS EINES FLUGZEUGS
ELECTRIC SYSTEM OF AN AIRCRAFT ELECTRIC PROPULSION

(30) Priorité: 11.08.2022 FR 2208258
(43) Date de publication de la demande: 18.06.2025
(73) Titulaire: Safran Electrical & Power, 31702 Blagnac (FR)
(72) Inventeur: CHAPERON, Vincent, CRAMAYEL 77550 (FR); NEHME, Samir, 77550 MOISSY-CRAMAYEL (FR); GUILLARD, Eric, 77550 MOISSY-CRAMAYEL (FR)
(74) Mandataire: Gevers & Orès
(86) Numéro de dépôt international: PCT/FR2023/051241
(87) Numéro de publication internationale: WO 2024/033589

(56) Documents cités:
- EP-A1- 3 849 062
- EP-A1- 4 020 716
- EP-A2- 0 869 029
- CN-B- 110 265 828
- JP-A- 2018 125 301
- JP-A- 2022 093 771
- US-A1- 2021 147 092
- US-B2- 8 631 571

## Description

### Domaine technique de l'invention

La présente invention concerne un système électrique d'une propulsion électrique d'un aéronef, ainsi qu'une propulsion électrique avec un tel système électrique et un aéronef avec une telle propulsion électrique. La présente invention concerne en outre un procédé de fabrication d'un système électrique d'une propulsion d'un aéronef.

### Arrière-plan technologique

Les aéronefs à propulsion électrique ou bien hybride (propulsion électrique et propulsion thermique), qu'ils soient à décollage et atterrissage verticaux (de l'anglais « Vertical Take Off and Landing », également désigné par le sigle VTOL), à décollage et atterrissage courts (de l'anglais « Short Take Off and Landing », également désigné par le sigle STOL), ou bien à décollage et atterrissage conventionnel (de l'anglais « Conventional Take Off and Landing », également désigné par le sigle CTOL), constituent un marché futur très prometteur avec des perspectives et une demande importantes dans le transport intra urbain et inter urbain pour des marchandises ou bien des personnes. La propulsion électrique de ces aéronefs est ainsi au moins en partie réalisée par un ou plusieurs moteurs électriques, le nombre variant suivant les architectures des aéronefs.

Ces propulsions électriques utilisent des circuits électriques avec des niveaux de tension toujours plus élevés, ce qui pose le problème des décharges partielles en altitude. En effet, des décharges partielles peuvent tout d'abord apparaître dans l'air entre deux conducteurs électriques à des potentiels différents, lorsque la distance dans l'air entre ces deux conducteurs n'est pas suffisante, c'est-à-dire inférieure à une distance d'isolement minimale. Des décharges partielles peuvent également se produire sur de la matière, le long d'une ou plusieurs pièces isolantes électriques s'étendant entre les deux conducteurs électriques. Les deux pièces doivent donc être séparées l'une de l'autre, le long d'une ligne de fuite sur la ou les pièces isolantes, d'une distance supérieure à une distance de fuite minimale. La distante de fuite minimale le long de la matière est supérieure à la distance d'isolement minimale dans l'air, selon un ratio augmentant avec l'altitude par exemple à cause de la réduction du niveau d'oxygène avec l'altitude.

Par ailleurs, la recherche de gain en masse pousse à chercher des solutions permettant de rapprocher les éléments les uns des autres. Dans le cas d'une carte électronique possédant des conducteurs électriques présentant respectivement le potentiel positif et négatif d'une tension continue d'alimentation (pouvant atteindre plusieurs centaines de volts), le respect de la distance d'isolement dans l'air et de la distance de fuite sur la matière impose de fortes contraintes sur le routage dans la carte électronique.

Il peut ainsi être souhaité de prévoir un système électrique d'une propulsion d'un aéronef, qui permette de s'affranchir d'au moins une partie des problèmes et contraintes précités.

Par ailleurs, la demande de brevet japonais JP 2022 093771 A décrit, avec les références de ce document, des conducteurs 31 supportés par un support 331 et avec une protection 10 à l'arrière des conducteurs 31.

### Résumé de l'invention

Il est donc proposé un système électrique d'une propulsion électrique d'un aéronef, caractérisé en ce qu'il comporte :
- un circuit électrique comportant un support plan isolant électrique et deux conducteurs électriques fixés au support plan, les deux conducteurs électriques étant conçu pour présenter, en fonctionnement du circuit électrique, des potentiels électriques respectifs différents, les deux conducteurs électriques étant séparés l'un de l'autre par une distance d'isolement dans l'air ; et
- une pièce intercalaire, isolante électrique, s'étendant sur le support plan, entre les deux conducteurs électriques, et présentant des reliefs de manière à définir une ligne de fuite entre les deux conducteurs électriques le long de la pièce intercalaire, cette ligne de fuite passant par les reliefs.

Ainsi, en passant par les reliefs, la ligne de fuite n'est plus droite mais « compressée » ce qui permet de rapprocher les conducteurs électriques l'un de l'autre, tant que la distance d'isolement dans l'air est suffisante. Dit autrement, les reliefs de la pièce permettent d'augmenter la longueur de la ligne de fuite, avec la même distance d'isolement dans l'air, afin de rapprocher les deux conducteurs électriques sans risque de décharges partielles. En outre, l'utilisation d'un pièce intercalaire permet d'éviter de prévoir les reliefs dans le support plan isolant électrique. En effet, l'usinage du support plan isolant peut s'avérer complexe et coûteux, par exemple lorsqu'il s'agit d'une carte électronique (de l'anglais « Printed Circuit Board »). En outre, il peut être compliqué de modifier le support plan isolant en cas d'erreur ou bien lorsque l'environnement du système électrique est amené à changer, par exemple lorsque l'altitude d'utilisation de l'aéronef est changée, ou bien lorsque le système électronique est modifié pour que la différence de potentiel soit plus élevée, ou bien lorsque le niveau de pollution et/ou d'humidité est différent de celui envisagé, etc. En revanche, il est facile de changer la pièce intercalaire, pour la remplacer par une nouvelle pièce intercalaire plus adaptée au nouvel environnement.

L'invention peut en outre comporter l'une ou plusieurs des caractéristiques optionnelles suivantes, selon toute combinaison techniquement possible.

De préférence, la pièce intercalaire est en au moins un parmi : Polyarylamide, Polyamide 6-6, Polysulfone, et Polyétheréthercétone.

De préférence également, les reliefs comportent au moins une rainure.

De préférence également, la rainure présente un profil transversal en créneau rectangulaire.

De préférence également, la rainure présente un profil transversal en trapèze.

De préférence également, la rainure présente une largeur égale à au moins 20% d'une longueur d'une ligne de fuite minimale pour éviter des décharges partielles entre les deux conducteurs électriques sur la pièce intercalaire.

De préférence également, la rainure présente une hauteur égale à au moins 25% d'une longueur d'une ligne de fuite minimale pour éviter des décharges partielles entre les deux conducteurs électriques sur la pièce intercalaire.

Il est également proposé une propulsion électrique d'un aéronef comportant un système électrique selon l'invention.

Il est également proposé un aéronef comportant une propulsion électrique selon l'invention.

Il est également proposé un procédé de fabrication d'un système électrique d'une propulsion électrique d'un aéronef, comportant :
- une obtention d'un circuit électrique ayant un support plan, isolant électrique, et deux conducteurs électriques fixés au support plan, les deux conducteurs électriques étant conçus pour présenter, en fonctionnement du circuit électrique, des potentiels électriques respectifs différents, les deux conducteurs électriques étant séparés l'un de l'autre par une distance d'isolement dans l'air ; le procédé comportant en outre :
- un ajout d'une pièce intercalaire, isolante électrique, de manière à s'étendre sur le support plan, entre les deux conducteurs électriques, la pièce intercalaire présentant des reliefs de manière à définir une ligne de fuite entre les deux conducteurs électriques le long de la pièce intercalaire, cette ligne de fuite passant par les reliefs.

De préférence, le procédé comporte :
- un calcul d'une distance d'isolement minimale entre les deux conducteurs électriques, par exemple en fonction d'au moins un parmi : une différence de potentiel maximale entre les deux conducteurs électriques en fonctionnement du circuit électrique, une altitude maximale que l'aéronef est conçu pour atteindre, à un niveau maximal de pollution que l'aéronef est conçu pour traverser et au niveau maximal d'humidité que l'aéronef est conçu pour traverser, le circuit électrique étant obtenu avec les deux conducteurs électriques espacés l'un de l'autre de la distance d'isolement dans l'air, cette dernière étant supérieure ou égale à la distance d'isolement minimale ;
- un calcul d'une longueur d'une ligne de fuite minimale à partir de l'altitude maximale que l'aéronef est conçu pour atteindre, par exemple à partir de la distance d'isolement minimale et d'un coefficient variant avec l'altitude par lequel la distance d'isolement minimale doit être multipliée pour obtenir la longueur de la ligne de fuite minimale ; et
- une conception des reliefs de la pièce intercalaire de sorte que la ligne de fuite présente une longueur supérieure ou égale à la longueur de la ligne de fuite minimale.

### Brève description des figures

L'invention sera mieux comprise à l'aide de la description qui va suivre, donnée uniquement à titre d'exemple et faite en se référant aux dessins annexés dans lesquels :
- la figure 1 est une vue de dessus d'une carte électronique, selon l'invention, d'un système électrique d'une propulsion électrique d'un aéronef, avec une pièce intercalaire entre deux conducteurs électriques,
- la figure 2 est une vue en coupe transversale d'un premier mode de réalisation d'une rainure de la pièce intercalaire,
- la figure 3 est une vue en coupe transversale d'un deuxième mode de réalisation d'une rainure de la pièce intercalaire,
- la figure 4 est une vue en coupe transversale de deux rainures selon le deuxième mode de réalisation,
- la figure 5 est une vue similaire à celle de la figure 1, sans utiliser la pièce intercalaire, et
- la figure 6 est un schéma-bloc illustrant les étapes d'un procédé selon l'invention, de mise en place d'une isolation électrique.

### Description détaillée de l'invention

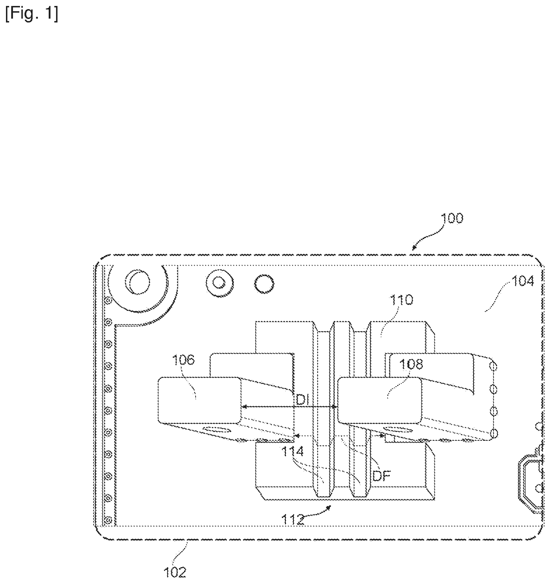

En référence à la figure 1, un exemple d'un système électrique 100 d'une propulsion d'un aéronef, selon l'invention, va à présent être décrit.

Le système électrique 100 comporte tout d'abord un circuit électrique 102 comportant un support plan 104 isolant électrique, par exemple une carte de circuit imprimé.

Le système électrique 100 comporte en outre deux conducteurs électriques 106, 108 fixés au support plan 104 conçus pour présenter en fonctionnement du circuit électrique 102, deux potentiels électriques respectifs différents. Il s'agit par exemple de bornes électriques conçues pour être respectivement connectées à des barres omnibus respectives et pour respectivement présenter un potentiel positif et un potentiel négative d'une tension continue d'alimentation, par exemple supérieure à 100 V. Alternativement, les conducteurs électriques 106, 108 pourraient être des barres omnibus, par exemple de transport de la tension continue d'alimentation, des plots, des contacteurs, ou bien encore des sondes de mesure.

Les deux conducteurs électriques 106, 108 sont séparés l'un de l'autre par une distance d'isolement DI dans l'air. La distance d'isolement DI est, par définition, la plus courte distance en ligne droite dans l'air entre les deux conducteurs 106, 108.

Pour éviter les décharges partielles au travers de l'air, la distance d'isolement DI doit être supérieure à une distance d'isolement minimale DIₘᵢₙ préalablement calculée par exemple en fonction d'au moins un parmi : de la différence de potentiel maximale entre les deux conducteurs en fonctionnement du circuit électrique, à l'altitude maximale que l'aéronef est conçu pour atteindre, au niveau maximal de pollution et au niveau maximal d'humidité que l'aéronef est conçu pour traverser. Généralement, les conducteurs électriques 106, 108 de sorte que la distance d'isolement DI soit égale à la distance d'isolement minimale DIₘᵢₙ.

Le système électrique 100 comporte en outre une pièce intercalaire 110, isolante électrique, s'étendant sur le support plan 104, entre les deux conducteurs électriques 106, 108. La pièce intercalaire 110 présente des reliefs 112 de manière à définir une ligne de fuite LF entre les deux conducteurs électriques 106, 108 le long de la pièce intercalaire 110, cette ligne de fuite LF passant par les reliefs 112. La ligne de fuite LF est, par définition, la plus courte distance courant sur la pièce intercalaire 110 entre les deux conducteurs 106, 108.

Pour éviter les décharges partielles le long de la pièce intercalaire 110, la ligne de fuite LF présente une longueur qui doit être supérieure à la longueur d'une ligne de fuite minimale LFₘᵢₙ égale à la distance d'isolement multipliée par un coefficient (plus grand que 1), ce coefficient augmentant avec l'altitude. Ainsi, le coefficient correspondant à l'altitude que l'aéronef est conçu pour atteindre est utilisé pour calculer la longueur de la ligne de fuite minimale LFₘᵢₙ.

Les reliefs 112 sont ainsi conçus pour que la longueur de la ligne de fuite LF soit égale ou supérieure à la longueur de la ligne de fuite minimale LFₘᵢₙ, de préférence égale.

Par exemple, les reliefs 112 comportent au moins une rainure 114 (deux dans l'exemple illustré), par exemple rectiligne et perpendiculaire à la ligne de fuite LF.

La pièce intercalaire est par exemple en au moins un parmi : Polyarylamide (souvent désigné par le sigle PAA), Polyamide 6-6 (souvent abrégé en PA66), Polysulfone (souvent désigné par le sigle PSU), et Polyétheréthercétone (souvent désigné par le sigle PEEK GLx, x allant de 1 à 30).

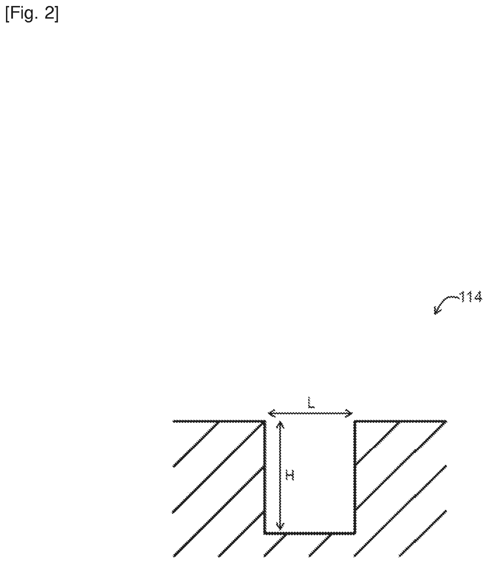

En référence à la figure 2, chaque rainure 114 peut présenter un profil transversal en créneau rectangulaire. De préférence, conformément à la norme EN60664-1 « isolement_système_basse_tension », la rainure 114 présente une largeur L égale à au moins 20% de la longueur de la ligne de fuite minimale LFₘᵢₙ et/ou une hauteur H égale à au moins 25% de longueur de la ligne de fuite minimale LFₘᵢₙ.

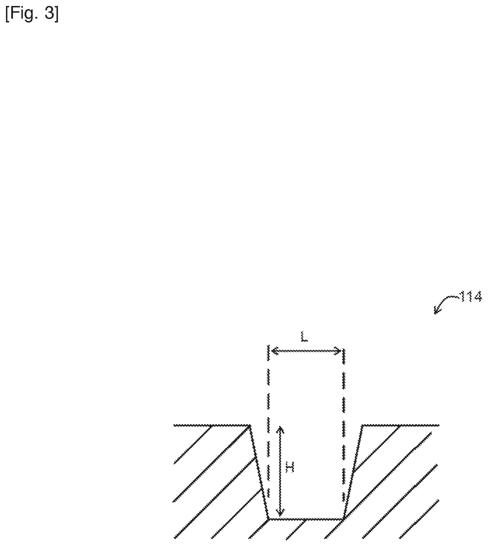

En référence à la figure 3, chaque rainure 114 peut également présenter un profil transversal en trapèze. De préférence, comme précédemment, la rainure 114 présente une largeur L (dimension de la base du trapèze, au fond de la rainure 114) égale à au moins 20% de la longueur de la ligne de fuite minimale LFₘᵢₙ et/ou une hauteur H égale à au moins 25% de la ligne de fuite minimale LFₘᵢₙ.

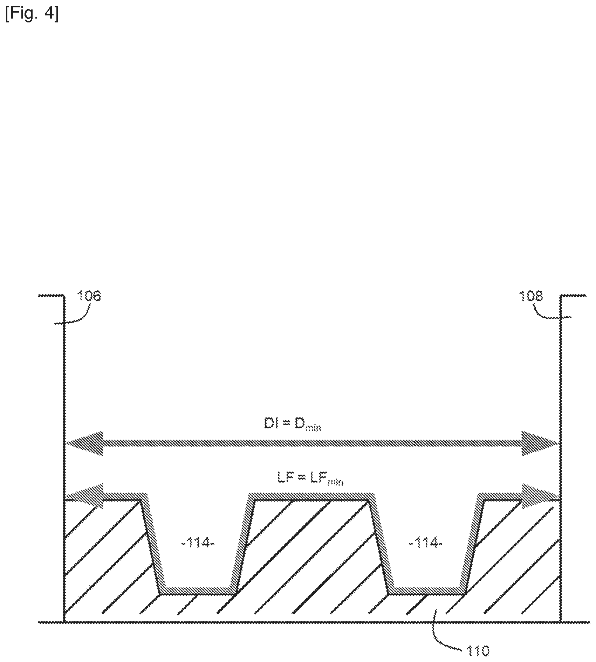

La figure 4 illustre le cas les rainures 114 sont dimensionnées de sorte que la longueur de la ligne de fuite LF soit égale à la longueur de la ligne de fuite minimale LFₘᵢₙ, avec la distance d'isolement DI égale à la distance d'isolement minimale DIₘᵢₙ. Dans ce cas, les conducteurs électriques 106, 108 sont rapprochés au maximum de ce qui est possible pour éviter des décharges partielles, compte tenu des hypothèse d'utilisation de l'aéronef retenues pour calculer la distance d'isolement minimale DIₘᵢₙ et la ligne de fuite minimale LFₘᵢₙ (différence de potentielle maximale, altitude, etc.).

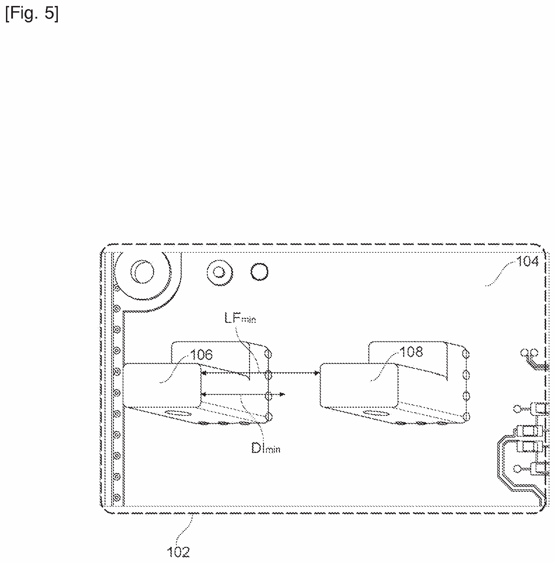

En référence à la figure 5, en l'absence de la pièce intercalaire 110, il faudrait écarter beaucoup plus les deux conducteurs électriques 106, 108 l'un de l'autre pour respecter la ligne de fuite minimale LFₘᵢₙ, prise dans l'exemple illustrée à 1,5 fois la distance d'isolement minimale DIₘᵢₙ.

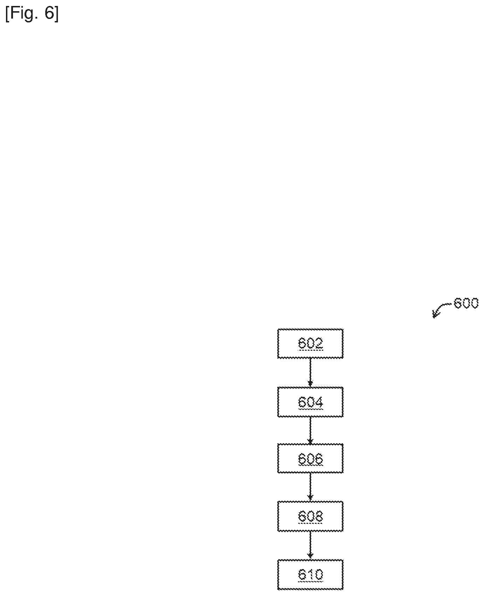

En référence à la figure 6, un procédé 600 de fabrication du système électrique 100 peut par exemple comporter les étapes suivantes.

Au cours d'une étape 602, la distance d'isolement minimale DIₘᵢₙ entre les deux conducteurs électriques 106, 108 est calculée, par exemple en fonction d'au moins un parmi : une différence de potentiel maximale entre les deux conducteurs électriques 106, 108 en fonctionnement du circuit électrique 102, une altitude maximale que l'aéronef est conçu pour atteindre, à un niveau maximal de pollution que l'aéronef est conçu pour traverser et au niveau maximal d'humidité que l'aéronef est conçu pour traverser.

Au cours d'une étape 604, le circuit électrique 102 est obtenu, sans la pièce intercalaire 110, avec les deux conducteurs électriques 106, 108 espacés l'un de l'autre de la distance d'isolement DI dans l'air, cette dernière étant supérieure ou égale à la distance d'isolement minimale DIₘᵢₙ. Par exemple, dans le cas où la pièce intercalaire 110 est destinée à remplacer une précédente pièce intercalaire présente entre les conducteurs électriques 106,108, qui n'est par exemple plus adaptée à un nouvel environnement du système électrique 100, l'étape 604 peut comporter la dépose de cette précédente pièce intercalaire.

Au cours d'une étape 606, la longueur d'une ligne de fuite minimale LFₘᵢₙ est calculée à partir de l'altitude maximale que l'aéronef est conçu pour atteindre, par exemple à partir de la distance d'isolement minimale DIₘᵢₙ et du coefficient variant avec l'altitude par lequel la distance d'isolement minimale DIₘᵢₙ est multipliée pour obtenir la longueur de la ligne de fuite minimale LFₘᵢₙ.

Au cours d'une étape 608, les reliefs 112 de la pièce intercalaire 110 sont conçus de sorte que la longueur de la ligne de fuite LF, une fois la pièce intercalaire ajoutée au circuit électrique 102, soit supérieure ou égale à la longueur de la ligne de fuite minimale LFₘᵢₙ.

Au cours d'une étape 610, la pièce intercalaire 110 avec les reliefs 112 préalablement conçus, est ajoutée au circuit électrique 102 de manière à s'étendre sur le support plan 104, entre les deux conducteurs électriques 106, 108. La ligne de fuite DF entre les deux conducteurs électriques 106, 108 le long de la pièce intercalaire 110 passe ainsi par les reliefs 112.

Il apparaît clairement qu'un système électrique tel que celui décrit précédemment permet augmenter la longueur de la ligne de fuite sur une distance plus courte dans l'air, à la limite égale à la distance d'isolement minimale.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, dans le cadre de l'invention telle que définie par les revendications.

Par exemple l'étape 606 et/ou l'étape 608 pourraient être réalisées avant l'étape 604.

Dans la présentation détaillée de l'invention qui est faite précédemment, les termes utilisés ne doivent pas être interprétés comme limitant l'invention aux modes de réalisation exposés dans la présente description.

## Revendications

1. Système électrique (100) d'une propulsion électrique d'un aéronef, comportant
- un circuit électrique (102) comportant un support plan (104), isolant électrique, et deux conducteurs électriques (106, 108) fixés au support plan, les deux conducteurs électriques (106, 108) étant conçus pour présenter, en fonctionnement du circuit électrique (102), des potentiels électriques respectifs différents, les deux conducteurs électriques (106, 108) étant séparés l'un de l'autre par une distance d'isolement (DI) dans l'air ; et
- une pièce intercalaire (110), isolante électrique, s'étendant sur le support plan (104), entre les deux conducteurs électriques (106, 108), **caractérisé en ce que** ladite pièce intercalaire présente des reliefs (112) de manière à définir une ligne de fuite (DF) entre les deux conducteurs électriques (106, 108) le long de la pièce intercalaire (110), cette ligne de fuite (DF) passant par les reliefs (112).

2. Système électrique (100) selon la revendication 1, dans lequel la pièce intercalaire est en au moins un parmi : Polyarylamide, Polyamide 6-6, Polysulfone, et Polyétheréthercétone.

3. Système électrique (100) selon la revendication 1 ou 2, dans lequel les reliefs (112) comportent au moins une rainure (114).

4. Système électrique (100) selon la revendication 3, dans lequel la rainure (114) présente un profil transversal en créneau rectangulaire.

5. Système électrique (100) selon la revendication 3, dans lequel la rainure (114) présente un profil transversal en trapèze.

6. Système électrique (100) selon l'une quelconque des revendications 3 à 5, dans lequel la rainure (114) présente une largeur (L) égale à au moins 20% d'une longueur d'une ligne de fuite minimale (LFₘᵢₙ) pour éviter des décharges partielles entre les deux conducteurs électriques (106, 108) sur la pièce intercalaire (110).

7. Système électrique (100) selon l'une quelconque des revendications 3 à 6, dans lequel la rainure (114) présente une hauteur (H) égale à au moins 25% d'une longueur d'une ligne de fuite minimale (LFₘᵢₙ) pour éviter des décharges partielles entre les deux conducteurs électriques (106, 108) sur la pièce intercalaire (110).

8. Propulsion électrique d'un aéronef comportant un système électrique selon l'une quelconque des revendications 1 à 7.

9. Aéronef comportant une propulsion électrique selon la revendication 8.

10. Procédé (600) de fabrication d'un système électrique (100) d'une propulsion électrique d'un aéronef, comportant :
- une obtention (604) d'un circuit électrique (102) ayant un support plan (104), isolant électrique, et deux conducteurs électriques (106, 108) fixés au support plan, les deux conducteurs électriques (106, 108) étant conçus pour présenter, en fonctionnement du circuit électrique (102), des potentiels électriques respectifs différents, les deux conducteurs électriques (106, 108) étant séparés l'un de l'autre par une distance d'isolement (DI) dans l'air ; le procédé comportant en outre :
- un ajout (610) d'une pièce intercalaire (110), isolante électrique, de manière à s'étendre sur le support plan (104), entre les deux conducteurs électriques (106, 108), la pièce intercalaire (110) présentant des reliefs (112) de manière à définir une ligne de fuite (DF) entre les deux conducteurs électriques (106, 108) le long de la pièce intercalaire (110), cette ligne de fuite (DF) passant par les reliefs (112).

11. Procédé (600) selon la revendication 10, comportant :
- un calcul (602) d'une distance d'isolement minimale (DIₘᵢₙ) entre les deux conducteurs électriques (106, 108), par exemple en fonction d'au moins un parmi : une différence de potentiel maximale entre les deux conducteurs électriques (106, 108) en fonctionnement du circuit électrique (102), une altitude maximale que l'aéronef est conçu pour atteindre, à un niveau maximal de pollution que l'aéronef est conçu pour traverser et au niveau maximal d'humidité que l'aéronef est conçu pour traverser, le circuit électrique (102) étant obtenu (604) avec les deux conducteurs électriques (106, 108) espacés l'un de l'autre de la distance d'isolement (DI) dans l'air, cette dernière étant supérieure ou égale à la distance d'isolement minimale (DIₘᵢₙ) ;
- un calcul (606) d'une longueur d'une ligne de fuite minimale (LFₘᵢₙ) à partir de l'altitude maximale que l'aéronef est conçu pour atteindre, par exemple à partir de la distance d'isolement minimale (DIₘᵢₙ) et d'un coefficient variant avec l'altitude par lequel la distance d'isolement minimale (DIₘᵢₙ) doit être multipliée pour obtenir la longueur de la ligne de fuite minimale (LFₘᵢₙ) ; et
- une conception (608) des reliefs (112) de la pièce intercalaire (110) de sorte que la ligne de fuite (LF) présente une longueur supérieure ou égale à la longueur de la ligne de fuite minimale (LFₘᵢₙ).

## Patentansprüche

1. Elektrisches System (100) eines elektrischen Antriebs eines Flugzeugs, umfassend:
- eine elektrische Schaltung (102), die eine elektrisch isolierende Stützfläche (104) und zwei elektrische Leiter (106, 108), die an der Stützfläche befestigt sind, umfasst, wobei die zwei elektrischen Leiter (106, 108) so ausgestaltet sind, dass sie im Betrieb der elektrischen Schaltung (102) jeweils unterschiedliche elektrische Potenziale aufweisen, wobei die zwei elektrischen Leiter (106, 108) durch einen Isolierabstand (DI) in der Luft voneinander getrennt sind; und
- ein elektrisch isolierendes Zwischenstück (110), das sich auf der Stützfläche (104) zwischen den zwei elektrischen Leitern (106, 108) erstreckt;
**dadurch gekennzeichnet, dass** das Zwischenstück Reliefs (112) derart aufweist, dass ein Kriechweg (DF) zwischen den zwei elektrischen Leitern (106, 108) entlang dem Zwischenstück (110) definiert wird, wobei dieser Kriechweg (DF) durch die Reliefs (112) verläuft.

2. Elektrisches System (100) nach Anspruch 1, wobei das Zwischenstück aus mindestens einem der folgenden ist: Polyarylamid, Polyamid 6-6, Polysulfon, und Polyetherertherceton.

3. Elektrisches System (100) nach Anspruch 1 oder 2, wobei die Reliefs (112) mindestens eine Nut (114) umfassen.

4. Elektrisches System (100) nach Anspruch 3, wobei die Nut (114) ein rechteckig gezacktes Querprofil aufweist.

5. Elektrisches System (100) nach Anspruch 3, wobei die Nut (114) ein trapezförmiges Querprofil aufweist.

6. Elektrisches System (100) nach einem der Ansprüche 3 bis 5, wobei die Nut (114) eine Breite (L) gleich mindestens 20% einer Länge eines minimalen Kriechwegs (LFₘᵢₙ) aufweist, um Teilentladungen zwischen den zwei elektrischen Leitern (106, 108) auf dem Zwischenstück (110) zu verhindern.

7. Elektrisches System (100) nach einem der Ansprüche 3 bis 6, wobei die Nut (114) eine Höhe (H) gleich mindestens 25% einer Länge eines minimalen Kriechwegs (LFₘᵢₙ) aufweist, um Teilentladungen zwischen den zwei elektrischen Leitern (106, 108) auf dem Zwischenstück (110) zu verhindern.

8. Elektrischer Antrieb eines Flugzeugs, das ein elektrisches System nach einem der Ansprüche 1 bis 7 umfasst.

9. Flugzeug, das einen elektrischen Antrieb nach Anspruch 8 umfasst.

10. Verfahren (600) zur Herstellung eines elektrischen Systems (100) eines elektrischen Antriebs eines Flugzeugs, umfassend:
- ein Erhalten (604) einer elektrischen Schaltung (102), die eine elektrisch isolierende Stützfläche (104) und zwei elektrische Leiter (106, 108), die an der Stützfläche befestigt sind, aufweist, wobei die zwei elektrischen Leiter (106, 108) so ausgestaltet sind, dass sie im Betrieb der elektrischen Schaltung (102) jeweils unterschiedliche elektrische Potenziale aufweisen, wobei die zwei elektrischen Leiter (106, 108) durch einen Isolierabstand (DI) in der Luft voneinander getrennt sind; wobei das Verfahren weiter umfasst:
- eine Anfügung (610) eines elektrisch isolierenden Zwischenstücks (110) derart, dass es sich auf der Stützfläche (104) zwischen den zwei elektrischen Leitern (106, 108) erstreckt, wobei das Zwischenstück (110) Reliefs (112) derart aufweist, dass ein Kriechweg (DF) zwischen den zwei elektrischen Leitern (106, 108) entlang dem Zwischenstück (110) definiert wird, wobei dieser Kriechweg (DF) durch die Reliefs (112) verläuft.

11. Verfahren (600) nach Anspruch 10, umfassend:
- eine Berechnung (602) eines minimalen Isolierabstands (DIₘᵢₙ) zwischen den zwei elektrischen Leitern (106, 108), beispielsweise als Funktion mindestens eines aus: einer maximalen Potenzialdifferenz zwischen den zwei elektrischen Leitern (106, 108) im Betrieb der elektrischen Schaltung (102), einer maximalen Höhe, für deren Erreichen das Flugzeug ausgestaltet ist, einem maximalen Verschmutzungsniveau, für dessen Durchquerung das Flugzeug ausgestaltet ist, und einem maximalen Feuchtigkeitsniveau, für dessen Durchquerung das Flugzeug ausgestaltet ist, wobei die elektrische Schaltung (102) mit den zwei elektrischen Leitern (106, 108) um den Isolierabstand (DI) in der Luft voneinander beabstandet erhalten wird (604), wobei dieser Letztere größer oder gleich dem minimalen Isolierabstand (DIₘᵢₙ) ist;
- eine Berechnung (606) einer Länge eines minimalen Kriechwegs (LFₘᵢₙ) ausgehend von der maximalen Höhe, für deren Erreichen das Flugzeug ausgestaltet ist, beispielsweise ausgehend von dem minimalen Isolierabstand (DIₘᵢₙ) und einem mit der Höhe variierenden Koeffizienten, mit dem der minimale Isolierabstand (DIₘᵢₙ) multipliziert werden muss, um die Länge des minimalen Kriechwegs (LFₘᵢₙ) zu erhalten, und
- eine Ausgestaltung (608) der Reliefs (112) des Zwischenstücks (110) auf solche Weise, dass der Kriechweg (LF) eine Länge aufweist, die größer oder gleich der Länge des minimalen Kriechwegs (LFₘᵢₙ) ist.

## Claims

1. An electrical system (100) of an electric propulsion unit of an aircraft, comprising:
- an electric circuit (102) comprising an electrically insulating flat support (104) and two electric conductors (106, 108) secured to the flat support, the two electric conductors (106, 108) being designed to have different respective electric potentials during operation of the electric circuit (102), the two electric conductors (106, 108) being separated from one another by an air insulation distance (DI); and
- an electrically insulating spacer (110) extending over the flat support (104), between the two electric conductors (106, 108),
**characterized in that** said spacer has reliefs (112) so as to define a leakage path (DF) between the two electric conductors (106, 108) along the spacer (110), this leakage path (DF) passing through the reliefs (112).

2. The electrical system (100) according to claim 1, wherein the spacer is made of at least one of: Polyarylamide, Polyamide 6-6, Polysulfone, and Polyetheretherketone.

3. The electrical system (100) according to claim 1 or 2, wherein the reliefs (112) comprise at least one groove (114).

4. The electrical system (100) according to claim 3, wherein the groove (114) has a rectangular cross-sectional profile.

5. The electrical system (100) according to claim 3, wherein the groove (114) has a trapezoidal cross-sectional profile.

6. The electrical system (100) according to any one of claims 3 to 5, wherein the groove (114) has a width (L) equal to at least 20% of a length of a minimum leakage path (LFₘᵢₙ) to avoid partial discharges between the two electric conductors (106, 108) on the spacer (110).

7. The electrical system (100) according to any one of claims 3 to 6, wherein the groove (114) has a height (H) equal to at least 25% of a length of a minimum leakage path (LFₘᵢₙ) to avoid partial discharges between the two electric conductors (106, 108) on the spacer (110).

8. An electric propulsion unit of an aircraft comprising an electrical system according to any one of claims 1 to 7.

9. An aircraft comprising an electric propulsion unit according to claim 8.

10. A method (600) of manufacturing an electrical system (100) of an electric propulsion unit of an aircraft, the method comprising:
- obtaining (604) an electric circuit (102) having an electrically insulating flat support (104) and two electric conductors (106, 108) secured to the flat support, the two electric conductors (106, 108) being designed to have different respective electric potentials in operation of the electric circuit (102), the two electric conductors (106, 108) being separated from one another by an air insulation distance (DI); the method further comprising:
- adding (610) an electrically insulating spacer (110) so as to extend over the flat support (104), between the two electric conductors (106, 108), the spacer (110) having reliefs (112) so as to define a leakage path (DF) between the two electric conductors (106, 108) along the spacer (110), this leakage path (DF) passing through the reliefs (112).

11. The method (600) according to claim 10, comprising:
- calculating (602) a minimum insulation distance (DIₘᵢₙ) between the two electric conductors (106, 108), for example as a function of at least one of: a maximum potential difference between the two electric conductors (106, 108) during operation of the electric circuit (102), at a maximum altitude that the aircraft is designed to reach, a maximum level of pollution that the aircraft is designed to pass through and at the maximum level of humidity that the aircraft is designed to pass through, the electric circuit (102) being obtained (604) with the two electric conductors (106, 108) spaced apart by the air insulation distance (DI), the latter being greater than or equal to the minimum insulation distance (DIₘᵢₙ);
- calculating (606) a length of a minimum leakage path (LFₘᵢₙ) from the maximum altitude that the aircraft is designed to reach, for example from the minimum insulation distance (DIₘᵢₙ) and a coefficient varying with altitude by which the minimum insulation distance (DIₘᵢₙ) must be multiplied to obtain the length of the minimum leakage path (LFₘᵢₙ); and
- designing (608) the reliefs (112) of the spacer (110) so that the leakage path (LF) has a length greater than or equal to the length of the minimum leakage path (LFₘᵢₙ).
